# EUROPEAN PATENT APPLICATION

(11) **EP 2 966 691 A1**
(43) Date of publication of application: **13.01.2016**
(21) Application number: 15176184.8
(22) Date of filing: 10.07.2015
(51) Int. Cl.: H01L 29/786, H01L 29/66

(54) **COATING LIQUID FOR PRODUCING N-TYPE OXIDE SEMICONDUCTOR, FIELD-EFFECT-TRANSISTOR, DISPLAY ELEMENT, IMAGE DISPLAY DEVICE, AND SYSTEM**

(30) Priority: 11.07.2014 JP 2014142953; 01.06.2015 JP 2015111494
(71) Applicant: Ricoh Company, Ltd., Tokyo 143-8555 (JP)
(72) Inventor: UEDA, Naoyuki, Tokyo, 143-8555 (JP); NAKAMURA, Yuki, Tokyo, 143-8555 (JP); ABE, Yukiko, Tokyo, 143-8555 (JP); MATSUMOTO, Shinji, Tokyo, 143-8555 (JP); SONE, Yuji, Tokyo, 143-8555 (JP); SAOTOME, Ryoichi, Tokyo, 143-8555 (JP); ARAE, Sadanori, Tokyo, 143-8555 (JP); KUSAYANAGI, Minehide, Tokyo, 143-8555 (JP)
(74) Representative: Schwabe - Sandmair - Marx

(57) **Abstract**

A field-effect transistor, including: a gate electrode configured to apply gate voltage; a source electrode and a drain electrode configured to take out electric current; an active layer formed of a n-type oxide semiconductor, and provided in contact with the source electrode and the drain electrode; and a gate insulating layer provided between the gate electrode and the active layer, wherein the n-type oxide semiconductor includes at least one selected from the group consisting of Re, Ru, and Os as a dopant.

## Description

### BACKGROUND OF THE INVENTION

### Field of the Invention

The present invention relates to: a coating liquid for producing a n-type oxide semiconductor; a field-effect transistor; a display element; an image display device; and a system.

### Description of the Related Art

A field-effect transistor (FET) is a transistor which controls electric current passed between a source electrode and a drain electrode by voltage is applied to a gate electrode to provide a gate for a flow of electrons or holes with applying an electric field to a channel.

The FET has been used as a switching element or an amplifying element, because of properties thereof. Since an FET shows a small gate current and has a flat profile, it can be easily manufactured or integrated compared to a bipolar transistor. For these reasons, the FET is an indispensable element used in many of integrated circuits of current electric devices.

The FET is applied in, for example, an active matrix display as a thin film transistor (TFT).

In recent years, liquid crystal displays (LCDs), organic EL (electroluminescent) displays (OLEDs), electronic paper, and the like have been made into practical use as flat panel displays (FPDs).

These FPDs are driven by a driving circuit containing TFT using amorphous silicon or polycrystalline silicon in an active layer. There are demands for the FPD to be increased in the size, resolution, and driving speed thereof. Along with these demands, TFTs are required to have higher carrier mobility, less characteristic change over time, and less inter-element characteristic variations in a panel.

However, TFTs using amorphous silicon (a-Si) or polycrystalline silicon (particularly, low temperature polysilicon: Low-Temperature Poly Silicon: LTPS) for an active layer have advantages and disadvantages. Therefore, it has been difficult to achieve all of the requirements at the same time.

For example, the a-Si TFT has disadvantages that the mobility thereof is insufficient to drive a LCD (large-screen liquid crystal display) at high speed, and that a large shift of the threshold voltage occurs when being continuously driven. The LTPS-TFT has large mobility, but has problems that variations in threshold voltage is large, as an active layer is crystallized by excimer laser annealing, and a mother glass size of a production line cannot be made large.

Therefore, there is a need for a novel TFT technology, which has both an advantage of a-Si TFT and an advantage of LTPS-TFT. In order to meet this need, development of TFT using an oxide semiconductor, to which carrier mobility superior to that of a-Si can be expected, has been recently actively carried out.

Particularly, InGaZnO₄(a-IGZO), which can be formed into a film at room temperature, and exhibits greater mobility in the amorphous state than that of a-Si, is disclosed (see, K.Nomura, and five others, "Room-temperature fabrication of transparent flexible thin-film transistors using amorphous oxide semiconductors", NATURE, VOL. 432, No. 25, NOVEMBER, 2004, pp. 488-492). Since this disclosure, numerous researches on an amorphous oxide semiconductor having high mobility have been actively conducted.

However, an oxygen concentration of the aforementioned oxide semiconductor needs to be precisely controlled during a film forming process, as carrier electrons are generated by oxygen vacancy. If it is attempted to realize high mobility, the oxide semiconductor tends to be in a depression state, and a process window for realizing normally-off is extremely narrow. Moreover, the oxygen concentration in the film is changed by patterning or passivation process after forming the oxide semiconductor film, and therefore the properties thereof tend to be deteriorated.

In order to solve the aforementioned problems, a countermeasure has been conventionally studied based on two viewpoints. The first viewpoint is to compensate carriers generated by oxygen vacancy with introduction of a p-type dopant (e.g., substituting In³⁺ with Zn²⁺) to thereby maintain the carrier concentration low (see Japanese Patent Application Laid-Open (JP-A) Nos. 2002-76356 and 2006-165529). In association with this method, it is also attempted to add a small amount of counter cations to stabilize the p-type dopant (for example, substituting In³⁺ with Zn²⁺, and adding a trace amount of Sin⁴⁺ ([Zn²⁺]>[Sn⁴⁺])) (see International Publication No. WO2008-096768). The other is a method, in which a certain amount of a metal element (e.g., Al, Zr, and Hf) having high affinity to oxygen is introduced to prevent generation of carriers (see, J. S. Park, and five others, "Novel ZrInZnO Thin-film Transistor with Excellent Stability", Advanced Materials, VOL. 21, No. 3, 2009, pp. 329-333).

However, all of the methods had a problem, such as insufficient stability, and low mobility.

### SUMMARY OF THE INVENTION

The present invention aims to solve the various problems in the art and to achieve the following object. That is, an object of the present invention is to provide a field-effect transistor including an active layer formed of an oxide semiconductor and having stable property and excellent device property.

A means for solving the aforementioned problems is as follows.

A field-effect transistor of the present invention includes:
a gate electrode configured to apply gate voltage;
a source electrode and a drain electrode configured to take out electric current;
an active layer formed of a n-type oxide semiconductor, and provided in contact with the source electrode and the drain electrode; and
a gate insulating layer provided between the gate electrode and the active layer,
wherein the n-type oxide semiconductor includes at least one selected from the group consisting of Re, Ru, and Os as a dopant.

According to the present invention, the present invention can solve the aforementioned problems in the art, and can provide a field-effect transistor including an active layer formed of an oxide semiconductor and having stable property and excellent device property.

### BRIEF DESCRIPTION OF THE DRAWINGS

FIG. 1 is a schematic configuration diagram illustrating one example of a top contact/bottom gate field-effect transistor.
FIG. 2 is a schematic configuration diagram illustrating one example of a bottom contact/bottom gate field-effect transistor.
FIG. 3 is a schematic configuration diagram illustrating one example of a top contact/top gate field-effect transistor.
FIG. 4 is a schematic configuration diagram illustrating one example of a bottom contact/top gate field-effect transistor.
FIG. 5 is a schematic configuration diagram illustrating one example of a television device as the system of the present invention.
FIG. 6 is a diagram for explaining the image display device of FIG. 5 (part 1).
FIG. 7 is a diagram for explaining the image display device of FIG. 5 (part 2).
FIG. 8 is a diagram for explaining the image display device of FIG. 5 (part 3).
FIG. 9 is a diagram for explaining one example of the display element of the present invention.
FIG. 10 is a schematic configuration diagram illustrating one example of a positional relationship between an organic EL element and a field-effect transistor in a display element.
FIG. 11 is a schematic configuration diagram illustrating another example of a positional relationship between an organic EL element and a field-effect transistor in a display element.
FIG. 12 is a schematic configuration diagram illustrating one example of an organic EL element.
FIG. 13 is a diagram for explaining a display control device.
FIG. 14 is a diagram for explaining a liquid crystal display.
FIG. 15 is a diagram for explaining the display element of FIG. 14.
FIG. 16 is a diagram for explaining properties of the field-effect transistors of Example 1 and Comparative Example 1.
FIG. 17 is a diagram for explaining relationships between the oxygen concentration during the formation of the active layer and field-effect mobility, as properties of the field-effect transistor of Example 1 and Comparative Example 1.
FIG. 18 is a diagram for explaining properties of the field-effect transistor of Example 6.
FIG. 19 is a diagram for explaining properties of the field-effect transistor of Comparative Example 2.

### DETAILED DESCRIPTION OF THE INVENTION

### (Field-effect transistor)

A field-effect transistor of the present invention contains at least a gate electrode, a gate insulating layer, an active layer, a source electrode, and a drain electrode, and may further contain other members.

### <Gate electrode>

The gate electrode is appropriately selected depending on the intended purpose without any limitation, provided that it is an electrode for applying gate voltage.

A material of the gate electrode is appropriately selected depending on the intended purpose without any limitation, and examples thereof include a metal (e.g., Mo, Al, Au, Ag, and Cu) an alloy thereof, transparent electroconductive oxide (e.g., ITO, and ATO), and an organic electroconductor (e.g., polyethylenedioxythiopnene (PEDOT), and polyaniline (PANI)).

A formation method of the gate electrode is appropriately selected depending on the intended purpose without any limitation, and examples thereof include: (i) a method where a film is formed by a sputtering method or a dip coating method, followed by patterning the film through photolithography; and (ii) a method where a film of the predetermined shape is directly formed through printing process, such as inkjet printing, nanoimprint lithography, and gravure printing.

An average thickness of the gate electrode is not particularly limited and may be appropriately selected depending on the intended purpose, but it is preferably 20 nm to 1 µm, more preferably 50 nm to 300 nm.

### <Gate insulating layer>

The gate insulating layer is appropriately selected depending on the intended purpose without any limitation, provided that it is an insulating layer provided between the gate electrode and the active layer.

A material of the gate insulating layer is appropriately selected depending on the intended purpose without any limitation, and examples thereof include: materials which have been widely used in manufacturing, such as SiO₂, and SiNₓ; high dielectric constant materials, such as La₂O₃, ZrO₂, and HfO₂; and organic materials, such as polyimide (PI), and a fLuororesin.

A formation method of the gate insulating layer is appropriately selected depending on the intended purpose without any limitation, and examples thereof include a vacuum film forming method (e.g., sputtering, chemical vapor deposition (CVD), and atomic layer deposition (ALD)), and a printing method (e.g., spin coating, die coating, and inkjet printing).

The average thickness of the gate insulating layer is appropriately selected depending on the intended purpose without any limitation, but the average thickness thereof is preferably 50 nm to 3 µm, more preferably 100 nm to 1 µm.

### <Active layer>

The active layer is a layer provided in contact with the source electrode and the drain electrode.

In the previous research conducted by the present inventors, it was disclosed that electrons carriers are generated in a highly symmetric oxide semiconductor by a n-type doping (see, JP-A No. 2011-192971), but it was problematic in that a relation between an oxide semiconductor and a dopant is limited in the aforementioned research. However, in the present research the inventors have found further more useful dopants as described below. In the present invention, by using the specific dopants, the generation efficiency of a carrier is higher than the invention described in JP-A No. 2011-192971, and thus the dopant concentration may be low. Accordingly, a component scattering a carrier is low, which less affects mobility.

According to the present invention, the active layer is a n-type oxide semiconductor which includes at least one selected from the group consisting of Re, Ru, and Os as a dopant.

Moreover, according to the present invention, the dopant is preferably a heptavalent cation, an octavalent cation, or both thereof. That is, the n-type oxide semiconductor is preferably substitutionally doped with a dopant which is a heptavalent cation, an octavalent cation, or both thereof.

The valence of the dopant is greater than the valence of a metal ion (provided that the dopant is excluded) constituting the n-type oxide semiconductor.

Note that, the substitutional doping is also referred to as n-type doping.

Mn, which is the same group as Re in the periodic table, can exist in a heptavalent state in a compound such as potassium permanganate (KMnO4) that is a strong oxidant, and the valence of Mn is easily changed. Thus, it is more stable in a lower oxidation state (bivalent, trivalent, and tetravalent). Therefore, even if Mn is added to the n-type oxide semiconductor, its functions as the dopant are low. Fe, which is the same group as Ru and Os, is also stable in a bivalent or trivalent state, and does not function as the dopant.

The n-type oxide semiconductor preferably includes at least one selected from the group consisting of Li, Cu, Ag, Be, Mg, Ca, Sr, Ba, Zn, Cd, Al, Ga, In, Tl, Sc, Y, Ln, where Ln is a lanthanoid element, Ti, Zr, Hf, Si, Ge, Sn, Pb, V, Nb, Ta, Sb, Bi, Cr, Mo, W, and Te.

Regarding a n-type carrier doping to the oxide semiconductor, the dopant is preferably selected considering an ionic radius, coordination number, and orbital energy. The doping concentration is appropriately selected depending on, for example, a material of a host phase, a species of a dopant and a site to be substituted, a film forming process, and desired TFT properties. For example, when a SrIn₂O₄ film doped with Re is produced through a coating process, an ink adjusted to a desired atomic ratio [e.g., Re/(In+Re)=0.1 at%] may be prepared. In this case, since Re (heptavalent) substituting the In site forms a donor, the generation efficiency of the carriers is higher than, for example, SrIn₂O₄ doped with Sn (tetravalent), and good TFT property can be realized at a small doping amount (practically, the doping amount may be 1/4). For example, when a Cu₂WO₄ film doped with Re is produced by a sputtering method, a target doped with Re in an amount of about 0.1% may be prepared. Since Re substituting the W site forms a donor, formation of oxygen vacancy can be reduced by increasing an oxygen concentration of sputtering gas compared to that used in preparation of undoped Cu₂WO₄. In this case, moreover, contact resistance with the source and the drain electrodes can be controlled low by maintaining a carrier concentration, and therefore decrease of mobility can be prevented. In the sputtering process, moreover, the material goes through a highly excited state, and therefore carriers can be generated without heating a substrate. In this example, since a substituted site of a host phase is a hexavalent W, a heptavalent or an octavalent cation (e.g., Re, Ru, and Os), as described in the present invention, is necessary in order to generate carriers. Thus, Sn (tetravalent) and Nb (pentavalent) do not act as an effective dopant. This point is significantly different from the case where the aforementioned trivalent In site is substituted.

In the case where the oxide has a rigid structure even if a diffraction line is not observed through X-ray diffraction (XRD) and no long distance order is present (generally it is called an amorphous state), oxygen coordination polyhedra (e.g., WO₆ and InO₆ octahedra) and the linking form thereof (e.g., a chain of edge sharing InO₆) are maintained, and therefore substitutional doping can be effectively performed. In the aforementioned structure, the density of states originated from tail states unique to amorphous state is small, thus sub-gap absorption is small, and an optical degradation characteristic is superior to that of a material having a highly amorphous characteristic. On the other hand, doping is obviously effective, if the oxide is in a crystal state, and a grain boundary effect is small in the conduction band composed of 4s, 5s, or 6s bands of heavy-metal ions. In the case where a doping amount is excessively large, and segregation of a dopant is observed at a grain boundary, however, it is preferable to lower the dopant concentration. Moreover, it is preferred that post annealing be performed at 200°C to 300°C in order to improve adhesiveness and electric connection at the interface between the source-drain electrodes and the active layer. Moreover, annealing may be performed at higher temperature to enhance crystallinity.

An amount of the dopant in the n-type oxide semiconductor is not particularly limited and may be appropriately selected depending on the intended purpose, but from the viewpoints of mobility and turn-on property, it is preferably 0.001 at% to 1 at%, more preferably 0.005 at% to 0.5 at%, still more preferably 0.01 at% to 0.2 at% of atoms of a doping site in the n-type oxide semiconductor.

An average thickness of the active layer is not particularly limited and may be appropriately selected depending on the intended purpose, but it is preferably 5 nm to 1 µm, more preferably 10 nm to 0.5 µm.

A formation method of the active layer is not particularly limited and may be appropriately selected depending on the intended purpose. The active layer is preferably formed by coating a coating liquid for producing a n-type oxide semiconductor, which will be described hereinafter.

### <Source electrode and drain electrode>

The source electrode and the drain electrode are not particularly limited and may be appropriately selected depending on the intended purpose, so long as they are an electrode configured to take out electric current.

Materials of the source electrode and the drain electrode are not particularly limited and may be appropriately selected depending on the intended purpose, and metals such as Mo, Al, and Ag or alloys; transparent conductive oxides such as ITO and ATO; and organic conductors such as polyethylenedioxythiophene (PEDOT) and ponyaniline (PANI) can be used. Materials having relatively low work function such as Mo, TiN, and ITO are preferably used since carriers are effectively injected into a n-type oxide semiconductor.

A formation method of the source electrode and the drain electrode is appropriately selected depending on the intended purpose without any limitation, and examples thereof include the same methods to those listed in the explanation of the gate electrode.

The average thickness of each of the source electrode and the drain electrode is appropriately selected depending on the intended purpose without any limitation, but the average thickness thereof is preferably 20 nm to 1 µm, more preferably 50 nm to 300 nm.

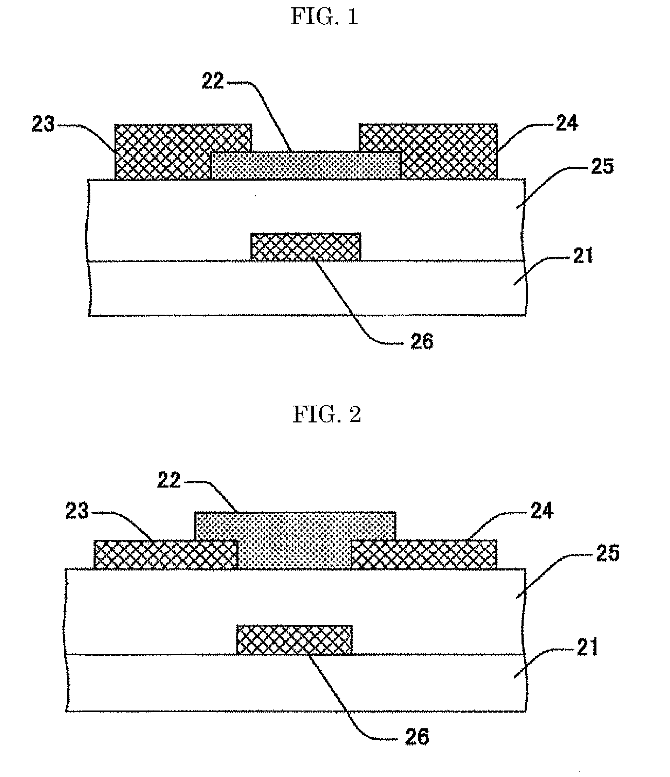

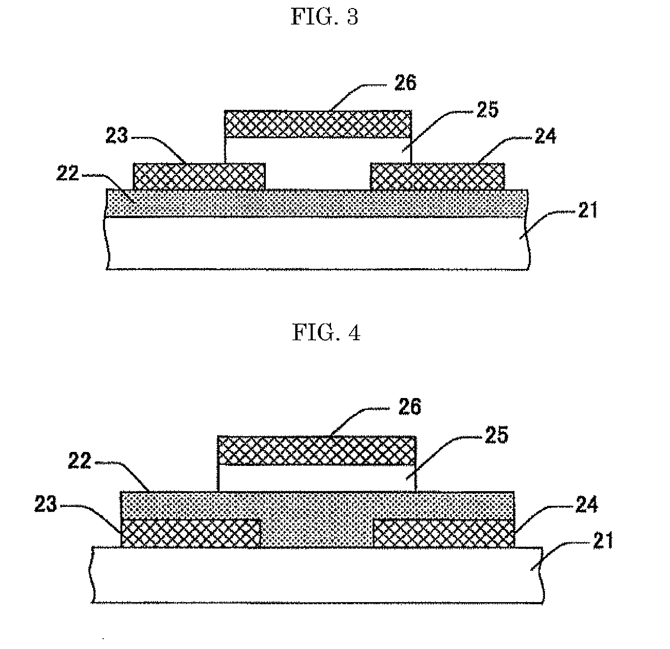

A structure of the field-effect transistor is appropriately selected depending on the intended purpose without any limitation, and examples thereof include top contact/bottom gate (FIG. 1), bottom contact/bottom gate (FIG. 2), top contact/top gate (FIG. 3), and bottom contact/top gate (FIG. 4).

Note that, in FIGs. 1 to 4, reference numeral 21 is a substrate, reference numeral 22 is an active layer, reference numeral 23 is a source electrode, reference numeral 24 is a drain electrode, reference numeral 25 is a gate insulating layer, and reference numeral 26 is a gate electrode.

The field-effect transistor is suitably used for the below-described display element, but use of the field-effect transistor is not limited to the display element. For example, the field-effect transistor can be used for IC cards, and ID tags.

### <Production method of field-effect transistor>

One example of a production method of the field-effect transistor is explained.

First, a gate electrode is formed on a substrate.

A shape, structure, and size of the substrate are appropriately selected depending on the intended purpose without any limitation.

The material of the substrate is appropriately selected depending on the intended purpose without any limitation, and examples thereof include a glass substrate, and a plastic substrate.

The glass substrate is appropriately selected depending on the intended purpose without any limitation, and examples thereof include alkali-free glass, and silica glass.

The plastic substrate is appropriately selected depending on the intended purpose without any limitation, and examples thereof include polycarbonate (PC), polyimide (PI), polyethylene terephthalate (PET), and polyethylene naphthalate (PEN).

Note that, a pre-treatment, such as oxygen plasma, UV ozone, and UV radiation washing, is preferably performed on the substrate to clean a surface thereof and to improve adhesion with another layer.

Subsequently, a gate insulating layer is formed on the gate electrode.

Then, an active layer composed of a n-type oxide semiconductor is formed on an area, which is a channel region and is above the gate insulating layer.

Subsequently, a source electrode and a drain electrode are formed with being apart from each other on the gate insulating layer in a manner that the source electrode and the drain electrode are respectively arranged at either side of the active layer.

In the manner as described above, a field-effect transistor is produced. In this production method, for example, a top contact/bottom gate field-effect transistor, as illustrated in FIG. 1, is produced.

According to the field-effect transistor of the present invention, electron carriers are efficiently generated by performing n-type substitutional doping in a n-type oxide semiconductor which is an active layer, and one can introduce a sufficient amount of oxygen into a film during formation of the film. It makes rigorous control of an oxygen concentration unnecessary and process margin wider. Moreover the stability of lattice is enhanced since the oxygen vacancy is decreased, which can realize that properties of the resultant product in post-process are stabilized. Accordingly, it is possible to reduce variations among elements, and an image display having a large area, high precise, and high quality can be realized.

### (Coating liquid for producing n-type oxide semiconductor)

A coating liquid for producing a n-type oxide semiconductor of the present invention includes at least one selected from the group consisting of a Re containing compound, a Ru containing compound, and an Os containing compound; and a solvent, preferably includes a semiconductor raw compound, and further includes other components if necessary.

The coating liquid for producing a n-type oxide semiconductor is used for producing a n-type oxide semiconductor containing at least one selected from the group consisting of Re, Ru, and Os as a dopant. The dopant is preferably at least one selected from the group consisting of a heptavalent cation and an octavalent cation.

The coating liquid for producing a n-type oxide semiconductor is preferably used for producing the n-type oxide semiconductor in the field-effect transistor of the present invention.

### <Re containing compound, Ru containing compound, and Os containing compound>

### -Re containing compound-

The Re (rhenium) containing compound is not particularly limited and may be appropriately selected depending on the intended purpose, but it is preferably an inorganic salt, an oxide, a hydroxide, an organic acid salt, an organometallic compound, a metal complex, or any combination thereof.

### -Ru containing compound-

The Ru (ruthenium) containing compound is not particularly limited and may be appropriately selected depending on the intended purpose, but it is preferably an inorganic salt, an oxide, a hydroxide, an organic acid salt, an organometallic compound, a metal complex, or any combination thereof.

### -Os containing compound-

The Os (osmium) containing compound is not particularly limited and may be appropriately selected depending on the intended purpose, but it is preferably an inorganic salt, an oxide, a hydroxide, an organic acid salt, an organometallic compound, a metal complex, or any combination thereof.

### <Solvent>

The solvent is not particularly limited and may be appropriately selected depending on the intended purpose, but it is preferably an organic solvent. As the organic solvent, glycol ethers, diols, and polar aprotic solvents (e.g., methylformamide, tetrahydrofuran, and lactones) are preferable.

### -Glycol ethers-

The glycol ethers greatly dissolve the semiconductor raw compound, the Re containing compound, the Ru containing compound, and the Os containing compound, and have high stability after dissolution. Thus, a n-type oxide semiconductor film having high uniformity and a small amount of defects can be obtained by using the glycol ethers in the coating liquid for producing a n-type oxide semiconductor.

Moreover, a n-type oxide semiconductor film having a desired shape can be formed with high precision by using the glycol ethers in the coating liquid for producing a n-type oxide semiconductor.

The glycol ethers are not particularly limited and may be appropriately selected depending on the intended purpose, but alkylene glycol monoalkyl ethers are preferable. The number of carbon atoms in the glycol ethers is preferably 3 to 8.

As the alkylene glycol monoalkyl ethers, ethylene glycol monoethyl ether, ethylene glycol monomethyl ether, ethylene glycol monopropyl ether, ethylene glycol monoisopropyl ether, ethylene glycol monobutyl ether, ethylene glycol monoisobutyl ether, propylene glycol monomethyl ether, and propylene glycol monobutyl ether are more preferable. These alkylene glycol monoalkyl ethers have a boiling point of about 120°C to about 180°C, which is not high very much, and are rapidly dried by virtue of their high evaporation rate. Therefore, the coating liquid for producing a n-type oxide semiconductor is hardly wet and spread of the composition may not occur. When such preferable compounds are contained in the coating liquid for producing a n-type oxide semiconductor, it is possible to lower a baking temperature and to bake the composition in a relatively short time. After baking the coating liquid, a n-type oxide semiconductor film containing a small amount of impurities such as carbons and organic matters can be obtained. As a result, carrier mobility is higher, and thus a gradient representing rising upon switching from OFF to ON becomes greater in a graph indicating a relationship between electric current (Ids) between the source-drain electrodes, and a gate voltage (Vgs) of the field-effect transistor in which the n-type oxide semiconductor film is used as the active layer. Thus, switching property becomes good, and driving voltage in order to obtain a necessary ON-current is lowered.

These may be used alone or in combination thereof.

When the alkylene glycol monoalkyl ether is mixed with a solvent having a relatively high boiling point such as the diols, a large amount of the solvent having a high boiling point is volatilized through azeotropy together with a solvent having a low boiling point, and thus an effect that a coating liquid for producing a n-type oxide semiconductor film is promptly dried is maintained. Therefore, since the solvent is promptly volatilized from the coating liquid which is discharged by an inkjet method and is jetted onto and spread over the substrate, the metal compounds dissolved are precipitated with a uniform formulation, and the composition of the n-type oxide semiconductor film after baking can be made uniform. Moreover, a shape of the n-type oxide semiconductor film during the course of drying the coating liquid is a small amount of concaves and convexes, and is relatively smooth.

Meanwhile, when the coating liquid for producing a n-type oxide semiconductor contains only a solvent having a high boiling point as a solvent, or a ratio of the amount of the solvent having a high boiling point in the solvent of the coating liquid for producing a n-type oxide semiconductor is too high, shape control after drying may be difficult since it takes time to dry the coating liquid jetted onto a substrate. Moreover, when the coating liquid for producing a n-type oxide semiconductor needs to be coated on top of another in the same part in order to form a thick film by an inkjet method, it is coated on top of another onto the coated liquid attached to the surface of the substrate before the solvent is completely volatilized. Thus, it is difficult to control a shape in both a direction of the substrate surface and a direction of the film thickness.

When a solvent having small molecular weight and low boiling point is used in the coating liquid for producing a n-type oxide semiconductor, the solvent easily volatilizes by virtue of high volatility in an inkjet nozzle and in a nozzle tip. As a result, the ink concentration is changed to thereby precipitate the matter contained therein, which causes nozzle clogging.

An amount of the glycol ethers in the coating liquid for producing a n-type oxide semiconductor is not particularly limited and may be appropriately selected depending on the intended purpose, but it is preferably 10% by mass to 80% by mass. When the amount thereof is less than 10% by mass, the aforementioned effects by incorporation of the glycol ethers (for example, an effect that a n-type oxide semiconductor film having high homogeneity and few defects can be obtained; an effect that a n-type oxide semiconductor film having a desired shape can be formed with high precision; and an effect that a n-type oxide semiconductor film having a lower volume resistivity can be obtained) may not be obtained. When the amount thereof is more than 80%, a thickness of the n-type oxide semiconductor film which can be formed through one time-coating may be thin.

### -Diols-

The glycol ethers are preferably used in combination with diols. When the glycol ethers are used in combination with the diols, it is possible by the action of the diols to eliminate clogging caused by drying of the solvent in an inkjet nozzle during coating of a film by an inkjet method. Moreover, by the effect of the glycol ethers, the coating liquid attached to a substrate is promptly dried, and the coating liquid is prevented from spreading to an unnecessary portion. For example, when a field-effect transistor is produced, the coating liquid attached to a channel region is promptly dried, and then the coating liquid is prevented from spreading out of the channel region.

Generally, the glycol ethers have a viscosity of about 1.3 cp to about 3.5 cp, which is low viscosity, and thus a viscosity of the coating liquid for producing a n-type oxide semiconductor can be easily adjusted by mixing diols having a high viscosity with the glycol ethers.

Also, it is believed that the diols are coordinated with a variety of metal salts, to thereby enhance chemical stability of the metal salts.

The diols are not particularly limited and may be appropriately selected depending on the intended purpose, but alkanediol and dialkyleneglycol are preferable. The number of carbon atoms in the diols is preferably 2 to 6. When the number thereof is 7 or more, the diols exhibit low volatility, easily remain in the formed n-type oxide semiconductor film, and the density of the n-type oxide semiconductor film may be lowered after baking. When the density of the n-type oxide semiconductor film is lowered, the carrier mobility may be lowered and On-state current may be reduced.

Since the diols having 2 to 6 carbon atoms have a boiling point of about 180°C to about 250°C, the aforementioned diols volatilize during baking after the coating liquid for producing a n-type oxide semiconductor is coated, and thus may not remain in the n-type oxide semiconductor film. Moreover, a viscosity of the diols is about 10 cp to about 110 cp. Therefore, when the coating liquid for producing a n-type oxide semiconductor is coated by, for example, an inkjet method, the coating liquid for producing a n-type oxide semiconductor is prevented from spreading during jetting onto a substrate.

When the coating liquid for producing a n-type oxide semiconductor is coated by spin coating or die coating, a film thickness may be easily controlled by adjusting a viscosity of the coating liquid for producing a n-type oxide semiconductor.

The diols are preferably diethylene glycol, dipropylene glycol, 1,2-ethanediol, 1,2-propanediol, 1,3-butanediol, or any combination thereof from the viewpoints of baking temperature and density of the n-type oxide semiconductor film after baking.

These may be used alone or in combination thereof.

### -Polar aprotic solvents -

The polar aprotic solvents greatly dissolve the semiconductor raw compound, the Re containing compound, the Ru containing compound, and the Os containing compound, and have high stability after dissolution. Thus, a n-type oxide semiconductor film having a high uniformity and a small amount of defects can be obtained by using the polar aprotic solvents in the coating liquid for producing a n-type oxide semiconductor.

Moreover, a n-type oxide semiconductor film having a desired shape can be formed with high precision by using the polar aprotic solvents in the coating liquid for producing a n-type oxide semiconductor.

The polar aprotic solvents are not particularly limited and may be appropriately selected depending on the intended purpose. For example, isophorone, propylene carbonate, tetrahydrofuran, dihydrofuran-2(3H)-one, dimethylformamide, dimethylacetamide, and 1,3-dimethyl-2-imidazolidinone are preferable.

These may be used alone or in combination thereof.

### <Semiconductor raw compound>

The semiconductor raw compound includes at least one selected from the group consisting of Li, Cu, Ag, Be, Mg, Ca, Sr, Ba, Zn, Cd, Al., Ga, In, Tl, Sc, Y, Ln, where Ln is a ranthanoid element, Ti, Zr, Hf, Si, Ge, Sn, Pb, V, Nb, Ta, Sb, Bi, Cr, Mo, W, and Te.

The semiconductor raw compound is preferably an inorganic salt, an oxide, a hydroxide, an organic acid salt, an organometallic compound, a metal complex, or any combination thereof.

In the coating liquid for producing a n-type oxide semiconductor, the semiconductor raw compound is preferably dissolved in the solvent with the Re containing compound, the Ru containing compound, the Os containing compound, or any combination thereof.

In the coating liquid for producing a n-type oxide semiconductor, a ratio of raw materials of the n-type oxide semiconductor (e.g., the semiconductor raw compound, the Re containing compound, the Ru containing compound, and the Os containing compound etc.) to the organic solvent (e.g., the diols, the glycol ethers and the polar aprotic solvents etc.) is not particularly limited and may be appropriately selected depending on the intended purpose, but a total amount of the raw materials of the n-type oxide semiconductor is preferably 0.1 mol to 2 mol relative to 1 L of the organic solvent. When the aforementioned content is less than 0.1 mol/L, a thickness of a film of the n-type oxide semiconductor film formed after baking may be too thin, so that it may be difficult to form a continuous film. Moreover, in order to obtain a film having a desired thickness, the resultant film may need to be repeatedly coated and dried. When the content is more than 2 mol/L, nozzle clogging may frequently occur at a tip of the inkjet nozzle during coating of the film by an inkjet method.

A method for producing the coating liquid for producing a n-type oxide semiconductor is not particularly limited and may be appropriately selected depending on the intended purpose.

### (Display element)

The display element of the present invention contains at least a light control element, and a driving circuit configured to drive the light control element, and may further contain other member according to the necessity.

### <Light control element>

The light control element is appropriately selected depending on the intended purpose without any limitation, provided that it is an element configured to control light output according to a driving signal. Examples of the light control element include an electroluminescent (EL) element, an electrochromic (EC) element, a liquid crystal element, an electrophoretic element, and an electrowetting element.

### <Driving circuit>

The driving circuit is appropriately selected depending on the intended purpose without any limitation, provided that it contains the field-effect transistor of the present invention.

### <Other members>

Other members are appropriately selected depending on the intended purpose without any limitation.

As the display element contains the field-effect transistor of the present invention, high-speed driving and long service life can be realized, and characteristic variations among elements can be reduced. Moreover, a driving transistor can be operated at constant gate electrode, even when a change in the display element occurs with time.

### (Image display device)

The image display device of the present invention contains at least a plurality of display elements, a plurality of lines, and a display control device, and may further contain other members according to the necessity.

### <Plurality of display elements>

A plurality of the display elements are appropriately selected depending on the intended purpose without any limitation, provided that they are a plurality of the display elements of the present invention provided in a matrix form.

### <Plurality of lines>

A plurality of the lines are appropriately selected depending on the intended purpose without any limitation, provided that they can individually apply gate voltage and signal voltage to each field-effect tranasistor in the display elements.

### <Display control device>

The display control device is appropriately selected depending on the intended purpose without any limitation, provided that it can individually control the gate voltage and the signal voltage of each field-effect transistor according to the image data through the lines.

### <Other members>

Other members are appropriately selected depending on the intended purpose without any limitation.

As the image display device contains the display element of the present invention, characteristic variations among elements can be reduced, and a large-screen image of high quality can be displayed.

### (System)

The system of the present invention contains at least the image display device of the present invention, and an image data generating device.

The image data generating device is configured to generate image data based on image information to be displayed, and to output the image data to the image display device.

Since the system is equipped with the image display device of the present invention, image information can be highly precisely displayed.

The display element, the image display device, and the system of the present invention are explained with reference to figures, hereinafter.

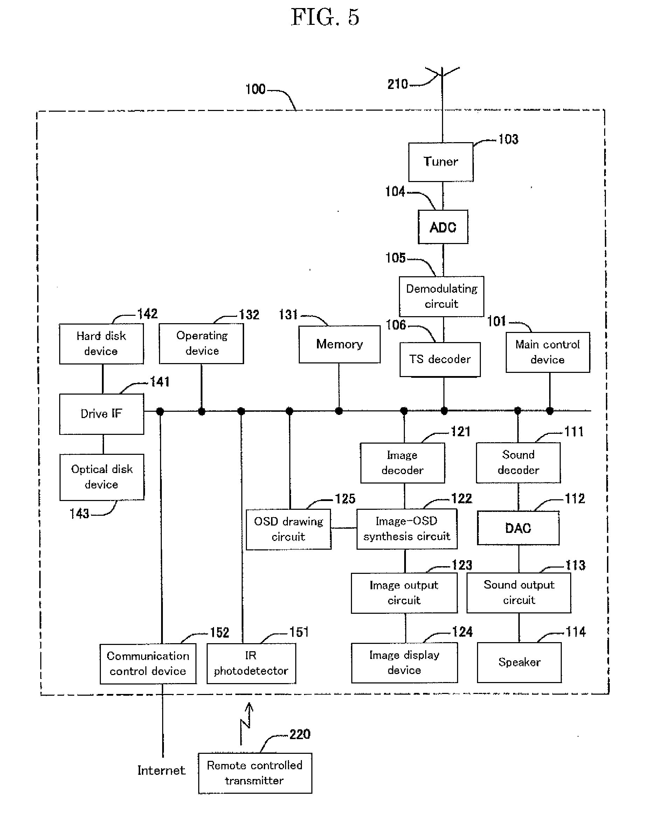

First, a television device as the system of the present invention is explained with reference to FIG. 5. Note that, the constitution of FIG. 5 is one example, and the television device as the system of the present invention is not limited to that illustrated in FIG. 5.

In FIG. 5, the television device 100 is equipped with a main control device 101, a tuner 103, an AD converter (ADC) 104, a demodulating circuit 105, transport stream (TS) decoder 106, a sound decoder 111, a DA converter (DAC) 112, a sound output circuit 113, a speaker 114, an image decoder 121, an image-OSD synthesis circuit 122, an image output circuit 123, an image display device 124, an OSD drawing circuit 125, a memory 131, an operating device 132, a drive interface (a drive IF) 141, a hard disk device 142, an optical disk device 143, an IR photodetector 151, and a communication control unit 152.

The image decoder 121, the image-OSD synthesis circuit 122, the image output circuit 123, and the OSD drawing circuit 125 constitute the image data creating device.

The main control device 101 is composed of CPU, flash ROM, and RAM, and is configured to control the entire television device 100.

In the flash ROM, a program written with a code that can be decoded with the CPU, and various data used for processing in the CPU are stored.

Moreover, RAM is a memory for operations.

The tuner 103 is configured to select channels, which have been set in advance, from the broadcast wave received by an aerial 210.

The ADC 104 is configured to convert the output signal (analog information) of the tuner 103 into digital information.

The demodulating circuit 105 is configured to demodulate the digital information from the ADC 104.

The TS decoder 106 is configured to TS decode the output signal of the demodulating circuit 105 to separate into sound information and image information.

The sound decoder 111 is configured to decode the sound information from the TS decoder 106.

The DA converter (DAC) 112 is configured to convert the output signal of the sound decoder 111 into analog signal.

The sound output circuit 113 is configured to output the output signal of the DA converter (DAC) 112 to the speaker 114.

The image decoder 121 is configured to decode the image information from the TS decoder 106.

The image-OSD synthesis circuit 122 is configured to synthesize an output signal of the image decoder 121 and an output signal of the OSD drawing circuit 125.

The image output circuit 123 is configured to output the output signals of the image-OSD synthesis circuit 122 to the image display device 124.

The OSD drawing circuit 125 is equipped with a character generator to display characters or graphics on a screen of the image display device 124, and is configured to generate a signal including display information based on the instructions from the operating device 132 and the IR photodetector 151.

The memory 131 is configured to temporarily store audio-visual (AV) data.

The operating device 132 is equipped with an input medium (not illustrated), such as a control panel, and is configured to inform various information, which has been input by a user, to the main control device 101.

The drive IF 141 is an interactive communication interface. As one example, the drive IF is according to ATA packet interface (ATAPI).

The hard disk device 142 is composed of a hard disk, and a driving device configured to drive the hard disk. The driving device records data on the hard disk, as well as reproducing the data recorded in the hard disk.

The optical disk device 143 records data on an optical disk (e.g., DVD), as well as reproducing the data recorded on the optical disk.

The IR photodetector 151 receives photosignal from a remote-controlled transmitter 220, and reports to the main control device 101.

The communication control unit 152 controls communication with internet. Various types of information can be obtained via internet.

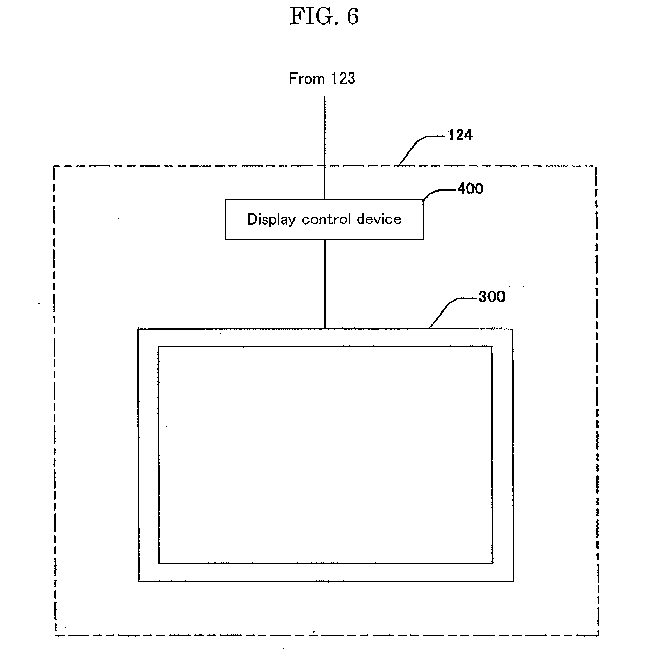

FIG. 6 is a schematic configuration diagram illustrating one example of the image display device of the present invention.

In FIG. 6, the image display device 124 contains a display unit 300, and a display control device 400.

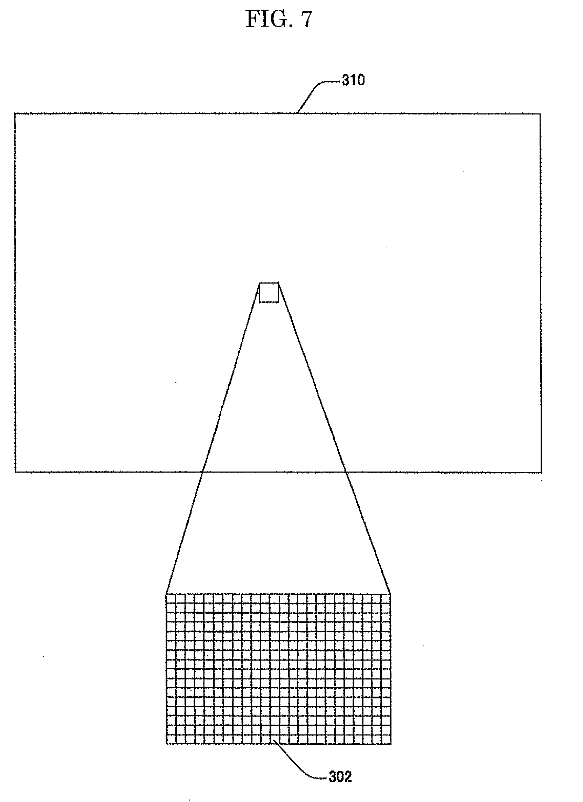

As illustrated in FIG. 7, the display unit 300 contains a display 310, in which a plurality (the number "n" x the number "m" in this case) of the display elements 302 are arranged in a matrix.

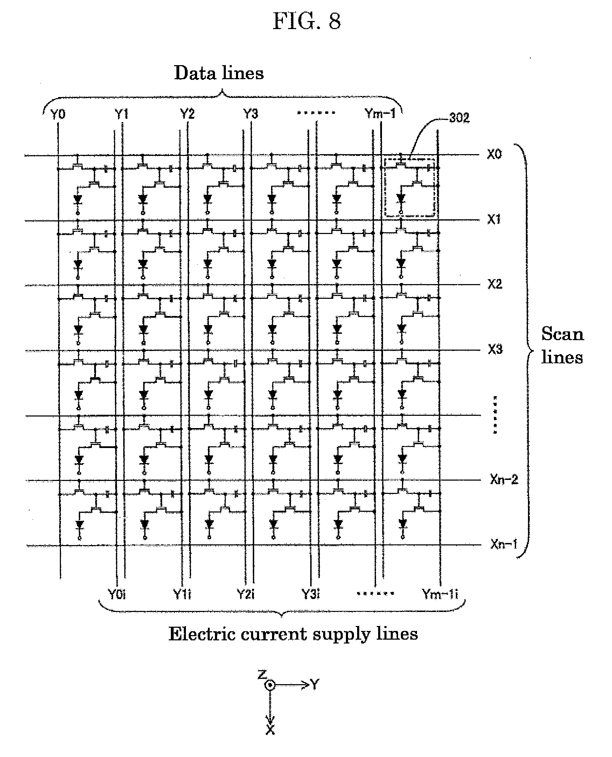

As illustrated in FIG. 8, moreover, the display 310 contains "n" number of scanning lines (X0, X1, X2, X3, ... Xn-2, Xn-1) arranged along the X axis direction with a constant interval, "m" number of data lines (Y0, Y1, Y2, Y3, ... Ym-1) arranged along the Y axis direction with a constant interval, and "m" number of current supply lines (Y0i, Y1i, Y2i, Y3i, ...Ym-1i) arranged along the Y axis direction with a constant interval.

As described, the display element is specified with the scanning line and the data line.

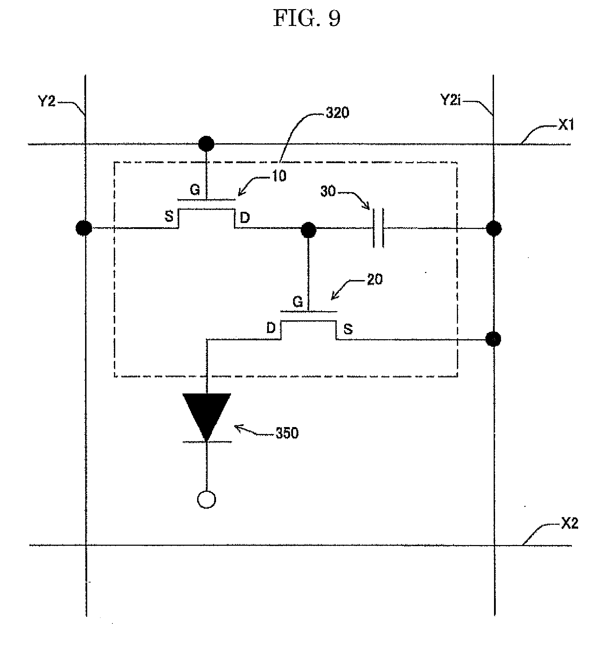

The display element of the present invention is explained with reference to FIG. 9, hereinafter.

FIG. 9 is a schematic configuration diagram illustrating one example of the display element of the present invention.

As illustrated in FIG. 9 as one example, the display element contains an organic electroluminescent (EL) element 350, and a driving circuit 320 configured to emit light from the organic EL element 350. The driving circuit 320 is a fundamental circuit of 2Tr-1C, which is electric current drive type, but it is not limited to the aforementioned circuit. That is, the display 310 is an organic EL display of a so-called active matrix system.

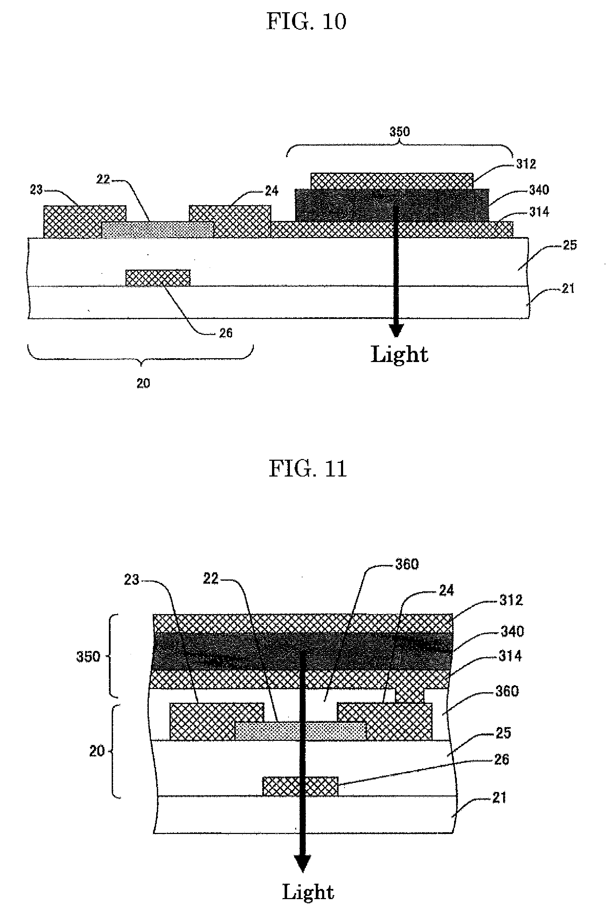

FIG. 10 illustrates a positional relationship between an organic EL element 350 and a field-effect transistor 20 as a driving circuit in a display element 302. In this example, the organic El element 350 is provided next to the field-effect transistor 20. Note that, the field-effect transistor 10 and a capacitor (not illustrated) are formed on the identical substrate.

Although it is not illustrated in FIG. 10, it is preferred that a passivation film is provided above the active layer 22. As for a material of the passivation film, SiO₂, SiNₓ, Al₂O₃, or a fluoropolymer is suitably used.

As illustrated in FIG. 11, for example, the organic EL element 350 may be provided on the field-effect transistor 20. In this case, transparency is required for the gate electrode 26. As for the gate electrode 26, therefore, a transparent electroconductive oxide, such as ITO, In₂O₃, SnO₂, ZnO, Ga-added ZnO, Al-added ZnO, and Sb-added SnO₂, is used. Note that, the reference number 360 represents an interlayer insulating film (a leveling film). As for the interlayer insulating film, polyimide, or an acrylic resin can be used.

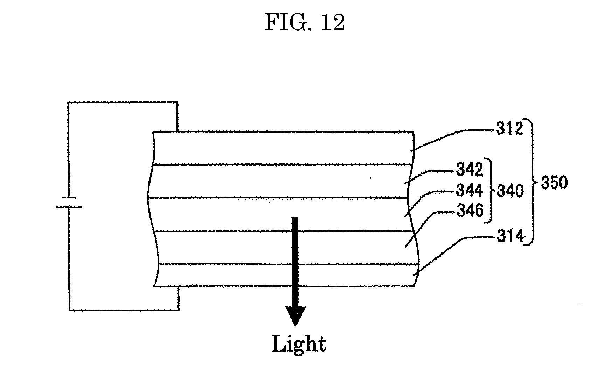

FIG. 12 is a schematic configuration diagram illustrating one example of an organic EL element.

In FIG. 12, the organic EL element 350 contains a cathode 312, an anode 314, and an organic EL film layer 340.

A material of the cathode 312 is appropriately selected depending on the intended purpose without any limitation, and examples thereof include aluminum (Al), magnesium (Mg)-silver (Ag) alloy, aluminum (Al)-lithium (Li) alloy, and indium tin oxide (ITO). Note that, the magnesium (Mg)-silver (Ag) alloy forms a high reflectance electrode with a sufficient thickness thereof, and an extremely thin film (less than about 20 nm) thereof forms a semi-transparent electrode. In FIG. 12, light is taken out from the side of the anode, but light can be taken out from the side of the cathode, by making the cathode a transparent or semi-transparent electrode.

A material of the anode 314 is appropriately selected depending on the intended purpose without any limitation, and examples thereof include indium tin oxide (ITO), indium zinc oxide (IZO), and silver (Ag)-neodymium (Nd) alloy. Note that, in the case where the silver alloy is used, a resulting electrode becomes a high reflectance electrode, which is suitable for taking light out from the side of the cathode.

The organic EL thin film layer 340 contains an electron transporting layer 342, a light emitting layer 344, and a hole transporting layer 346. The electron transporting layer 342 is connected to the cathode 312, and the hole transporting layer 346 is connected to the anode 314. The light emitting layer 344 emits light, as the predetermined voltage is applied between the anode 314 and the cathode 312.

Here, the electron transporting layer 342 and the light emitting layer 344 may form one layer. Moreover, an electron injecting layer may be provided between the electron transporting layer 342 and the cathode 312. Further, a hole injecting layer may be provided between the hole transporting layer 346 and the anode 314.

As for the light control element, moreover, the so-called "bottom emission" organic EL element, in which light is taken out from the side of the substrate, is explained. However, the light control element may be a "top emission" organic EL element, in which light is taken out from the opposite side to the substrate.

The driving circuit 320 of FIG. 9 is explained.

The driving circuit 320 contains two field-effect transistors 10, 20, and a capacitor 30.

The field-effect transistor 10 functions as a switching element. The gate electrode G of the field-effect transistor 10 is connected to the predetermined scanning lines, and the source electrode S of the field-effect transistor 10 is connected to the predetermined data line. Moreover, the drain electrode D of the field-effect transistor 10 is connected to one terminal of the capacitor 30.

The field-effect transistor 20 is configured to supply electric current to the organic EL element 350. The gate electrode G of the field-effect transistor 20 is connected to the drain electrode D of the field-effect transistor 10. The drain electrode D of the field-effect transistor 20 is connected to the anode 314 of the organic EL element 350, and the source electrode S of the field-effect transistor 20 is connected to the predetermined current supply line.

The capacitor 30 is configured to store a state of the field-effect transistor 10, i.e., data. The other terminal of the capacitor 30 is connected to the predetermined current supply line.

As the field-effect transistor 10 is turned in the state of "On," the image data is stored in the capacitor 30 via the signal line Y2. Even after turning the field-effect transistor 10 in the state of "Off," the field-effect transistor 20 is maintained in the state of "On" corresponding to the image data so that the organic EL element 350 is driven.

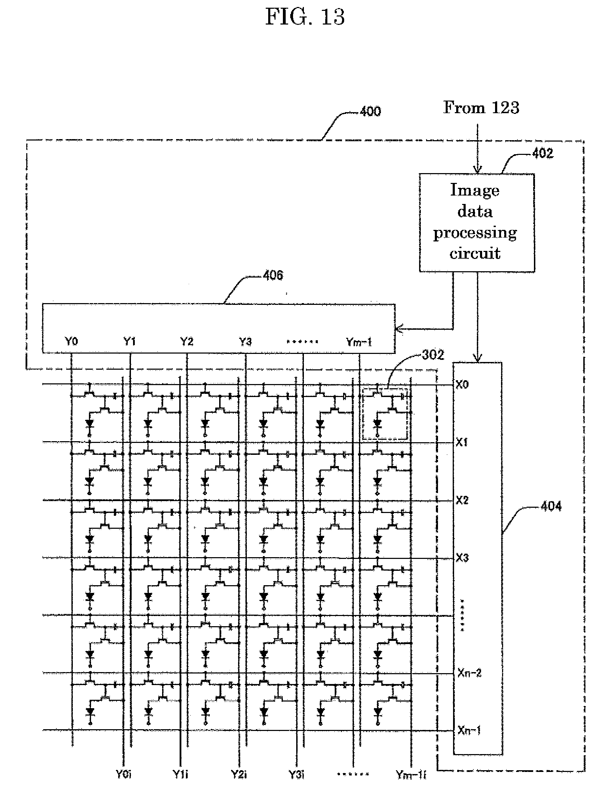

FIG. 13 is a schematic configuration diagram illustrating another example of the image display device of the present invention.

In FIG. 13, the image display device contains a display element 302, lines (scanning lines, data lines, and current supply lines), and a display control device 400.

The display control device 400 contains an image data processing circuit 402, a scanning line driving circuit 404, and a data line driving circuit 406.

The image data processing circuit 402 judges luminance of a plurality of the display elements 302 in the display based on output signal of the image output circuit 123.

The scanning line driving circuit 404 individually applies voltage to the number "n" of scanning lines according to the instructions of the image data processing circuit 402.

The data line driving circuit 406 individually applies voltage to the number "m" of data lines according to the instruction of the image data processing circuit 402.

The embodiment above explains the case where the light control element is an organic EL element, but the light control element is not limited to the organic EL element. For example, the light control element may be an electrochromic element. In this case, the display is an electrochromic display.

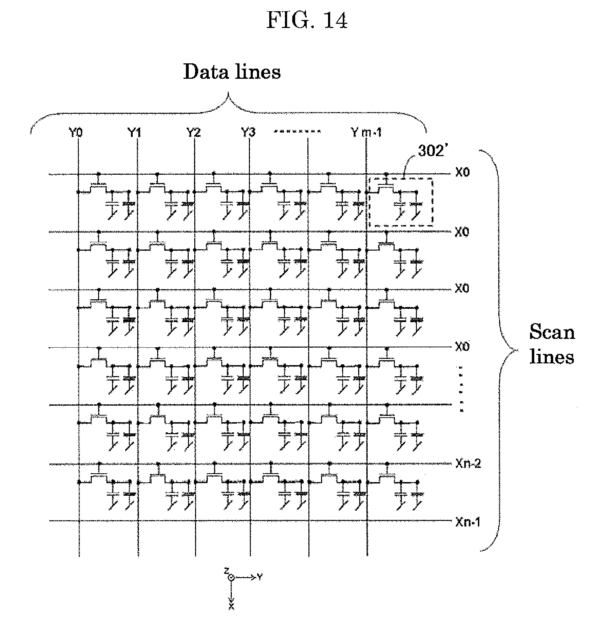

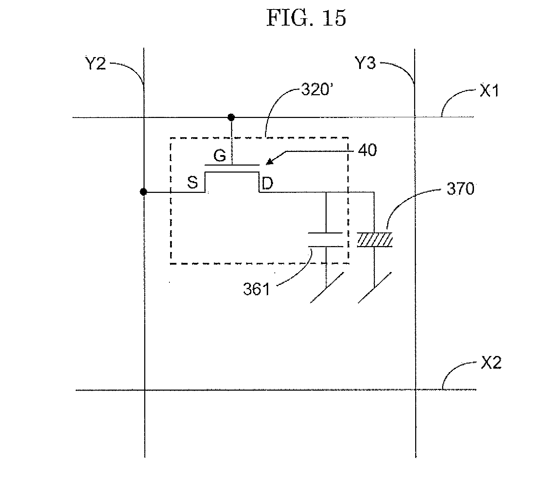

Moreover, the light control element may be a liquid crystal element. In this case, the display is a liquid crystal display, and a current supply line is not necessary to the display element 302' as illustrated in FIG. 14. As illustrated in FIG. 15, moreover, the driving circuit 320' may be composed of one field-effect transistor 40, which is identical to the field-effect transistors 10 and 20. In the field-effect transistor 40, the gate electrode G is connected to the predetermined scanning line, and the source electrode S is connected to the predetermined data line. Moreover, the drain electrode D is connected to the capacitor 361 and a pixel electrode of the liquid crystal element 370.

Moreover, the light control element may be an electrophoretic element, an inorganic EL element, or an electrowetting element.

The case where the system of the present invention is a television device is explained above, but the system is not limited as long as the system contains the image display device 124 as a device for displaying images and information. For example, the system may be a computer system, in which a computer (including a personal computer) is connected to the image display device 124.

Moreover, the image display device 124 can be used as a display unit in a mobile information device (e.g., a mobile phone, a portable music player, a portable video player, an electronic book, a personal digital assistant (PDA)), or a camera device (e.g., a still camera, a video camera). The image display device 124 can be used as a display unit for various types of information in a transport system (e.g., a car, an air craft, a train, and a ship). Furthermore, the image display device 124 can be used as a display unit for various types of information in a measuring device, an analysis device, a medical equipment, or advertising media.

### Examples

The present invention will be described with reference to the following Examples. However, it should be noted that the present invention is not limited to these Examples.

### (Example 1)

### <Formation of gate electrode>

An alkali-free glass substrate was subjected to ultrasonic washing using a neutral detergent, pure water, and isopropyl alcohol. After drying the substrate, the substrate was subjected to UV-ozone processing for 10 minutes at 90°C. A film of Mo having a thickness of 100 nm was formed on the alkali-free glass substrate by a DC magnetron sputtering method, and the film was patterned by photolithography, to thereby form a gate electrode.

### <Formation of gate insulating layer>

Next, a film of SiO₂ having a thickness of 200 nm was formed on the gate electrode and the alkali-free glass substrate by a RF magnetron sputtering method to thereby form a gate insulating layer.

### <Formation of active layer>

Next, a film of MgIn₂O₄ doped with Re [doping concentration: Re/(In+Re)=0.5 at%] having a thickness of 50 nm was formed using a sintered body target of MgIn_{1.99}Re_{0.01}O₄ by a RF magnetron sputtering method. As sputtering gas, argon gas and oxygen gas were introduced. The entire pressure was fixed at 1.1 Pa, and the oxygen concentration was varied in the range of 8 vol% to 90 vol% as a parameter, to thereby form an active layer on the gate insulating layer. The patterning was performed by forming the film through a metal mask.

### <Formation of source electrode and drain electrode>

Next, Al was deposited through a metal mask on the gate insulating layer and the active layer by vacuum evaporation to have a thickness of 100 nm, to thereby form source-drain electrodes. The channel length thereof was 50 µm, and the channel width thereof was 400 µm.

Finally, annealing was performed for 1 hour at 300°C in air, to thereby produce a field-effect transistor.

### (Comparative Example 1)

A field-effect transistor was produced in the same manner as in Example 1, provided that the sintered body target used in the formation of the active layer was changed to MgIn₂O₄ as depicted in Table 2, to thereby form an active layer.

### (Examples 2 to 5)

Each field-effect transistor was produced in the same manner as in Example 1, provided that the sintered body target used in the formation of the active layer was changed as depicted in Tables 3, to thereby form an active layer.

### (Example 6)

### <Preparation of coating liquid for producing n-type oxide semiconductor>

First, 0.1 mol (35.488 g) of indium nitrate (In(NO₃)₃•3H₂O) was weighted, and was dissolved in 100 mL of ethylene glycol monomethyl ether, to thereby obtain liquid A.

Next, 0.02 mol (7.503 g) of aluminum nitrate (Al(NO₃)₃•9H₂O) was weighted, and was dissolved in 100 mL of ethylene glycol monomethyl ether, to thereby obtain liquid B.

Then, 0.005 mol (1.211 g) of rhenium oxide (Re₂O₇) was weighted; and was dissolved in 500 mL of ethylene glycol monomethyl ether, to thereby obtain liquid C.

The liquid A (199.9 mL), the liquid B (50 mL), and the liquid C (10 mL) were mixed and stirred together with ethylene glycol monomethyl ether (160.1 mL) and 1,2-propanediol (420 mL) at room temperature, to thereby prepare a coating liquid for producing a n-type oxide semiconductor.

### <Formation of gate electrode>

An alkali-free glass substrate was subjected to ultrasonic washing using a neutral detergent, pure water, and isopropyl alcohol. After drying the substrate, the substrate was subjected to UV-ozone processing for 10 minutes at 90°C. A film of Mo having a thickness of 100 nm was formed on the alkali-free glass substrate by a DC magnetron sputtering method, and the film was patterned by photolithography, to thereby form a gate electrode.

### <Formation of gate insulating layer>

Next, a film of SiO₂ having a thickness of 200 nm was formed on the gate electrode and the alkali-free glass substrate by a RF magnetron sputtering method to thereby form a gate insulating layer.

### <Formation of source electrode and drain electrode>

Next, a film of ITO having a thickness of 100 nm was formed on the gate insulating layer by a DC magnetron sputtering method, and was patterned by photolithography, to thereby form a source electrode and a drain electrode.

### <Formation of active layer>

Next, the coating liquid for producing a n-type oxide semiconductor was coated on a channel region, a source electrode, and a drain electrode of the substrate by an inkjet method, and was baked at 300°C for 1 hour in air, to thereby produce a field-effect transistor.

### (Comparative Example 2)

### <Preparation of coating liquid for producing n-type oxide semiconductor>

First, 0.1 mol (35.488 g) of indium nitrate (In(NO₃)₃•3H₂O) was weighted and was dissolved in 100 mL of ethylene glycol monomethyl ether, to thereby obtain liquid A.

Next, 0.02 mol (7.503 g) of aluminum nitrate (Al(NO₃)₃•9H₂O) was weighted and was dissolved in 100 mL of ethylene glycol monomethyl ether, to thereby obtain liquid C.

The liquid A (100 mL) and the liquid C (50 mL) were mixed and stirred together with ethylene glycol monomethyl ether (60 mL) and 1,2-propanediol (210 mL) at room temperature, to thereby prepare a coating liquid for producing a n-type oxide semiconductor.

### <Formation of gate electrode>

An alkali-free glass substrate was subjected to ultrasonic washing using a neutral detergent, pure water, and isopropyl alcohol. After drying the substrate, the substrate was subjected to UV-ozone processing for 10 minutes at 90°C. A film of Mo having a thickness of 100 nm was formed on the alkali-free glass substrate by a DC magnetron sputtering method, and the film was patterned by photolithography, to thereby form a gate electrode.

### <Formation of gate insulating layer>

Next, a film of SiO₂ having a thickness of 200 nm was formed on the gate electrode and the alkali-free glass substrate by a RF magnetron sputtering method to thereby form a gate insulating layer.

### <Formation of source electrode and drain electrode>

Next, a film of ITO having a thickness of 100 nm was formed on the gate insulating layer by a DC magnetron sputtering method, and was patterned by photolithography, to thereby form a source electrode and a drain electrode.

### <Formation of active layer>

Next, the coating liquid for producing a n-type oxide semiconductor was coated on a channel region, a source electrode, and a drain electrode of the substrate by an inkjet method, and was baked at 300°C for 1 hour in air, to thereby produce a field-effect transistor.

### (Examples 7 to 10)

### <Preparation of coating liquid for producing n-type oxide semiconductor>

Each of the coating liquids for producing n-type oxide semiconductor of Examples 7 to 10 was prepared in the same manner as in Example 6 except that an amount of the coating liquid for producing a n-type oxide semiconductor was changed to each of the amounts shown in Table 1.

### <Production of field-effect transistor>

A field-effect transistor was produced in the same manner as in Example 6 except that the coating liquid for producing a n-type oxide semiconductor was changed to the coating liquid for producing a n-type oxide semiconductor produced above.

**Table 1**

| Example | | 7 | 8 | 9 | 10 |
|---|---|---|---|---|---|
| Material A | Compound | 2-Ethylhexanoic acid magnesium | Copper nitrate trihydrate | Zinc nitrate hexahydrate | Lead nitrate |
| | Amount (mmol) | 100 | 200 | 200 | 200 |
| Material B | Compound | Indium acetylacetonate | Tungsten chloride | Tin chloride | Niobium chloride |
| | Amount (mmol) | 199 | 99.8 | 99.9 | 199.8 |
| Material C | Compound | Methyltrioxorhe nium | Rhenium oxide | Ruthenium oxide | Osmium oxide |
| | Amount (mmol) | 1 | 0.2 | 0.1 | 0.2 |
| Solvent A | Compound | Diethylene glycol | 1, 2-Ethanediol | 1,2-Propane diol | 1,3-Butanediol |
| | Amount (mL) | 600 | 900 | 600 | 800 |
| Solvent B | Compound | Propylene glycol monobutyl ether | Ethylene glycol monobutyl ether | Ethylene glycol monomethyl ether | Dihydrofuran-2(3H)-one |
| | Amount (mL) | 600 | 900 | 600 | 800 |

### <Evaluation results>

Table 2 shows evaluation results of the field-effect transistors of Example 1 and Comparative Example 1 in mobility when each of the oxygen concentration during the film formation of the active layer was 8 vol% and 40 vol%.

Note that, the mobility was calculated by transfer property.

**Table 2**

| | Sputtering target | Mobility at oxygen concentration of 8 % by volume (cm²/Vs) | Mobility at oxygen concentration of 40 % by volume (cm²/Vs) |
|---|---|---|---|
| Example 1 | MgIn_{1.99}Re_{0.01}O₄ | 2.84 | 3.40 |
| Comparative Example 1 | MgIn₂O₄ | 2.93 | 0.29 |

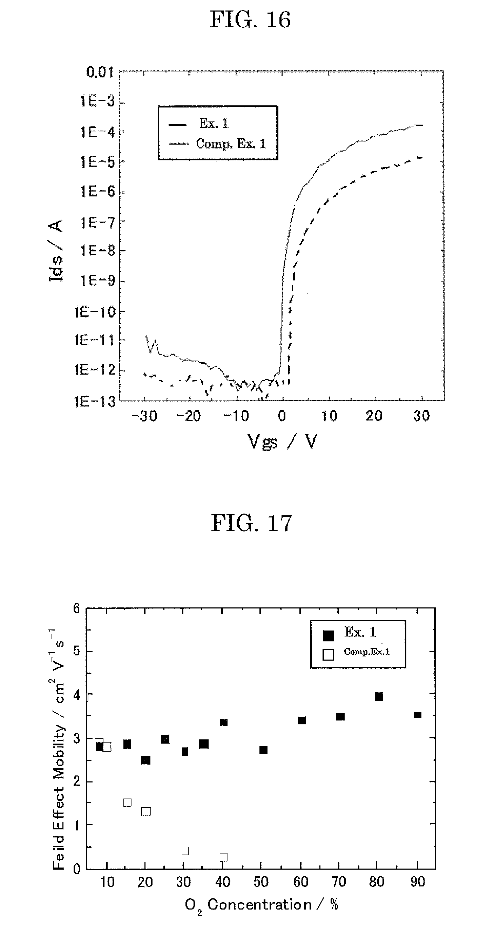

FIG. 16 shows transfer properties (Vds = 20 V) of the field-effect transistors of Example 1 and Comparative Example 1 with the oxygen concentration of 40 vol% during the formation of the active layer. In Example 1 where the active layer was doped with Re, the turn-on voltage (Von) was 0 V, the mobility was 3.40 cm²/Vs, and the on-off ratio was 8 digits, indicating excellent properties in normally-off. In Comparative Example 1 where no doping was performed on the active layer, the turn-on voltage (Von) was 1.0 V, the mobility was 0.29 cm²/Vs, and the on-off ratio was 7 digits. The turn-on voltage was shifted to the positive side and the mobility was reduced compared to Example 1.

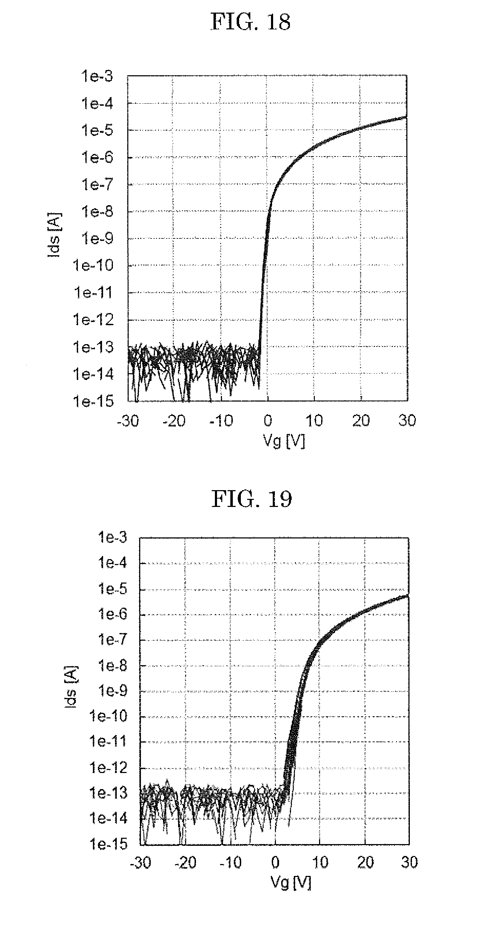

Note that, in FIG. 16, "E" denotes "the exponent of 10". In FIGs. 18 and 19, "e" denotes "the exponent of 10". For example, "1E-5" and "1e-5" represent "0.00001".

Moreover, relationships between the oxygen concentration during the formation of the active layer and field-effect mobility of the field-effect transistors of Example 1 and Comparative Example 1 are shown in FIG. 17.

In Example 1, the mobility was about 3.3 ± 0.6 cm²/Vs and substantially constant with the oxygen concentration of 8 vol% to 90 vol%, and the mobility thereof did not have a dependency to the oxygen concentration.

Meanwhile, in Comparative Example 1, the similar mobility to that of Example 1 was exhibited at the oxygen concentration of 8%, but the mobility monotonically decreased as the oxygen concentration increased. The mobility decreased to 1/10 at the oxygen concentration of 40 vol%.

The reasons for this were considered as follows. In Example 1, n-type doping was carried out by introducing Re, and carriers were generated from Re substituting the In site, and therefore, the carrier concentration was maintained to be substantially constant even when the oxygen concentration increased. In Comparative Example 1 where no doping was performed, oxygen vacancy in the active layer decreased as the oxygen concentration increased, thereby the carrier concentration decreased. As a result, the contact resistance with the source and the drain electrodes increased, and therefore reduction in the mobility was observed.

Next, Table 3 shows the evaluation results of field-effect transistors of Examples 2 to 5 in mobility at the oxygen concentration of 8 vol% and 40 vol % during the formation of the active layer. Similarly to Example 1, it was found that there was no change in the mobility between the oxygen concentration of 8 vol% and the oxygen concentration of 40 vol %. That is, it was considered that the substituting cations acted as a n-type dopant to generate electron carriers, and constant properties were exhibited regardless of the amount of oxygen.

**Table 3**

| | Sputtering target | Mobility at oxygen concentration of 8 vol% (cm²/Vs) | Mobility at oxygen concentration of 40 vol% (cm²/Vs) |
|---|---|---|---|
| Example 2 | Cu₂W_{0.998}Re_{0.002}O₄ | 2.69 | 2.58 |
| Example 3 | Zn₂Sn_{0.999}Ru_{0.001}O₄ | 3.24 | 3.35 |
| Example 4 | Al_{0.1}In_{1.999}Re_{0.001}O₃ | 3.56 | 3.87 |
| Example 5 | Pb₂Nb_{1.998}O_{S0.002}O₇ | 1.45 | 1.38 |

That is, the field-effect transistor containing, as an active layer, the n-type oxide semiconductor, in which electron carriers were generated through substitutional doping of cations, stably exhibited high mobility over a wide process range, and attained excellent properties of normally-off, compared to the field-effect transistor containing, as an active layer, the oxide semiconductor, in which carriers were generated by controlling only an oxygen amount.

Next, FIGs. 18 and 19 show twenty four transfer properties (Vds=20V) of the field-effect transistors of the samples of Example 6 and Comparative Example 2.

In Example 6, where the active layer was doped with Re [doping concentration: Re/(In+Re)=0.05 at%], the mobiliry (µ) was 1.62±0.04 cm²/Vs, the threshold voltage (Vth) was 3.20±0.14 V, and the subthreshold swing (Vss) was 0.4 V, indicating the low variation and excellent properties (FIG. 18).

Meanwhile, in Comparative Example 2, where no doping was performed in the active layer, the mobility (µ) was 0.62±0.04 cm²/Vs, the threshold voltage (Vth) was 11.2±0.38 V, and the subthreshold swing (Vss) was 0.6. The mobility was lowered, Vth was shifted to the enhancement mode, the variation was larger, and Vss was larger in comparison to Example 6 (FIG. 19).

Next, evaluation results of the field-effect transistors of Examples 7 to 10, where the same evaluations were conducted, are summarized together with Example 6 and Comparative Example 2 in Table 4. In Comparative Example 2, the threshold voltage is very high, the carriers are insufficient, and thus the reduction of the mobility is caused. Meanwhile, in Examples 6 to 10, it is found that carriers are sufficiently generated through the substitutional doping. Particularly, it is believed that the fact that low threshold voltage is observed in Example 7 where an amount of substitution is large, reflects the above. In Examples 6 to 10, the values of the mobility are each different depending on the materials of the semiconductor, but all of the variations of the threshold voltages are small compared with Comparative Example 2, indicating that stable, homogenous, good TFT properties are obtained through the substitutional doping with Re, Ru, or Os.

**Table 4**

| | Mobility (cm²/Vs) | Threshold voltage (V) | Subthreshold swing (V) |
|---|---|---|---|
| Example 6 | 1.62±0.04 | 3.20±0.14 | 0.4 |
| Example 7 | 1.21±0.03 | 2.38±0.11 | 0.3 |
| Example 8 | 1.84±0.03 | 3.54±0.15 | 0.4 |
| Example 9 | 2.07±0.03 | 3.11±0.13 | 0.3 |
| Example 10 | 1.43±0.04 | 3.04±0.16 | 0.3 |
| Comparative Example 2 | 0.62±0.04 | 11.2±0.38 | 0.6 |

As explained above, the field-effect transistor of the present invention is suitable for increasing a process margin, and stabilizing TFT properties at a high level. Moreover, the display element of the present invention can be driven at high speed, and is suitable for improving reliability with reducing variations among elements. The image display device of the present invention is suitably for displaying a high quality image with a large screen. Moreover, the system of the present invention can highly precisely display image information, and is suitably used for a television device, a computer system and so on.

Embodiments of the present invention are, for example, as follows:
<1> A field-effect transistor, including:
   a gate electrode configured to apply gate voltage;
   a source electrode and a drain electrode configured to take out electric current;
   an active layer formed of a n-type oxide semiconductor, and provided in contact with the source electrode and the drain electrode; and
   a gate insulating layer provided between the gate electrode and the active layer,
   wherein the n-type oxide semiconductor includes at least one selected from the group consisting of Re, Ru, and Os as a dopant.
<2> The field-effect transistor according to <1>, wherein the dopant is at least one selected from the group consisting of a heptavalent cation and an octavalent cation.
<3> The field-effect transistor according to <1> or <2>, wherein the n-type oxide semiconductor includes at least one selected from the group consisting of Li, Cu, Ag, Be, Mg, Ca, Sr, Ba, Zn, Cd, Al, Ga, In, Tl, Sc, Y, Ln, where Ln is a lanthanoid element, Ti, Zr, Hf, Si, Ge, Sn, Pb, V, Nb, Ta, Sb, Bi, Cr, Mo, W, and Te.
<4> A coating liquid for producing a n-type oxide semiconductor, which is used for producing the n-type oxide semiconductor containing at least one selected from the group consisting of Re, Ru, and Os as a dopant, the coating liquid including:
   at least one selected from the group consisting of a Re containing compound, a Ru containing compound, and an Os containing compound, and
   a solvent.
<5> The coating liquid for producing a n-type oxide semiconductor according to <4>, which is used for producing the n-type oxide semiconductor in the field-effect transistor according to any one of <1> to <3>.
<6> The coating liquid for producing a n-type oxide semiconductor according to <4> or <5>, wherein the solvent contains at least one selected from the group consisting of diols and glycol ethers.
<7> The coating liquid for producing a n-type oxide semiconductor according to any one of <4> to <6>, further including a semiconductor raw compound containing at least one selected from the group consisting of Li, Cu, Ag, Be, Mg, Ca, Sr, Ba, Zn, Cd, Al, Ga, In, Tl, Sc, Y, Ln, where Ln is a ranthanoid element, Ti, Zr, Hf, Si, Ge, Sn, Pb, V, Nb, Ta, Sb, Bi, Cr, Mo, W, and Te.
<8> The coating liquid for producing a n-type oxide semiconductor according to any one of <4> to <7>, wherein at least one selected from the group consisting of the Re containing compound, the Ru containing compound, and the Os containing compound is at least one selected from the group consisting of an inorganic salt, an oxide, a hydroxide, an organic acid salt, an organometallic compound, and a metal complex.
<9> The coating liquid for producing a n-type oxide semiconductor according to <7> or <8>, wherein the semiconductor raw compound is at least one selected from the group consisting of an inorganic salt, an oxide, a hydroxide, an organic acid salt, an organometallic compound, and a metal complex.
<10> A display element, including:
   a light control element configured to control light output corresponding to a driving signal; and
   a driving circuit, which contains the field-effect transistor according to any one of <1> to <3>, and is configured to drive the light control element.
<11> The display element according to <10>, wherein the light control element includes at least one selected from the group consisting of an electroluminescent element, an electrochromic element, a liquid crystal element, an electrophoretic element, and an electrowetting element.
<12> An image display device, which displays an image corresponding to an image data, the image display device including:
   a plurality of the display elements according to <10> or <11> arranged in a matrix;
   a plurality of lines configured to individually apply gate voltage and signal voltage to the field-effect transistors in each of the plurality of the display elements; and
   a display control device configured to individually control the gate voltage and the signal voltage of each of the field-effect transistors through the plurality of lines corresponding to the image data.
<13> A system, including:
   the image display device according to <12>; and
   an image data generating device, configured to generate an image data based on image information to be displayed, and to output the image data generated to the image display device.

## Claims

1. A field-effect transistor, comprising:
a gate electrode configured to apply gate voltage;
a source electrode and a drain electrode configured to take out electric current;
an active layer formed of a n-type oxide semiconductor, and provided in contact with the source electrode and the drain electrode; and
a gate insulating layer provided between the gate electrode and the active layer,
wherein the n-type oxide semiconductor includes at least one selected from the group consisting of Re, Ru and Os as a dopant.

2. The field-effect transistor according to claim 1, wherein the dopant is at least one selected from the group consisting of a heptavalent cation and an octavalent cation.

3. The field-effect transistor according to claim 1 or 2, wherein the n-type oxide semiconductor includes at least one selected from the group consisting of Li, Cu, Ag, Be, Mg, Ca, Sr, Ba, Zn, Cd, Al, Ga, In, Tl, Sc, Y, Ln, where Ln is a lanthanoid element, Ti, Zr, Hf, Si, Ge, Sn, Pb, V, Nb, Ta, Sb, Bi, Cr, Mo, W, and Te.

4. A coating liquid for producing a n-type oxide semiconductor, which is used for producing the n-type oxide semiconductor containing at least one selected from the group consisting of Re, Ru, and Os as a dopant, the coating liquid comprising:
at least one selected from the group consisting of a Re containing compound, a Ru containing compound, and an Os containing compound; and
a solvent.

5. The coating liquid for producing a n-type oxide semiconductor according to claim 4, which is used for producing the n-type oxide semiconductor in the field-effect transistor according to any one of claims 1 to 3.

6. The coating liquid for producing a n-type oxide semiconductor according to claim 4 or 5, wherein the solvent contains at least one selected from the group consisting of diols and glycol ethers.

7. The coating liquid for producing a n-type oxide semiconductor according to any one of claims 4 to 6, further comprising a semiconductor raw compound containing at least one selected from the group consisting of Li, Cu, Ag, Be, Mg, Ca, Sr, Ba, Zn, Cd, Al, Ga, In, Tl, Sc, Y, Ln, where Ln is a ranthanoid element, Ti, Zr, Hf, Si, Ge, Sn, Pb, V, Nb, Ta, Sb, Bi, Cr, Mo, W, and Te.

8. The coating liquid for producing a n-type oxide semiconductor according to any one of claims 4 to 7, wherein at least one selected from the group consisting of the Re containing compound, the Ru containing compound, and the Os containing compound is at least one selected from the group consisting of an inorganic salt, an oxide, a hydroxide, an organic acid salt, an organic metal, and a metal complex.

9. The coating liquid for producing a n-type oxide semiconductor according to claim 7 or 8, wherein the semiconductor raw compound is at least one selected from the group consisting of an inorganic salt, an oxide, a hydroxide, an organic acid salt, an organic metal, and a metal complex.

10. A display element, comprising:
a light control element configured to control light output corresponding to a driving signal; and
a driving circuit, which comprises the field-effect transistor according to any one of claims 1 to 3, and is configured to drive the light control element.

11. The display element according to claim 10, wherein the light control element comprises at least one selected from the group consisting of an electroluminescent element, an electrochromic element, a liquid crystal element, an electrophoretic element, and an electrowetting element.

12. An image display device, which displays an image corresponding to an image data, the image display device comprising:
a plurality of the display elements according to claim 10 or 11 arranged in a matrix;
a plurality of lines configured to individually apply gate voltage and signal voltage to the field-effect transistors in each of the plurality of the display elements; and
a display control device configured to individually control the gate voltage and the signal voltage of each of the field-effect transistors through the plurality of lines corresponding to the image data.

13. A system, comprising:
the image display device according to claim 12; and
an image data generating device, configured to generate an image data based on image information to be displayed, and to output the image data generated to the image display device.
